**Europäisches Patentamt**

**European Patent Office**

**Office européen des brevets**

(11) Veröffentlichungsnummer: **0 254 200**
**A1**

## (12) EUROPÄISCHE PATENTANMELDUNG

(21) Anmeldenummer: **87110229.9**

(22) Anmeldetag: **15.07.87**

(51) Int. Cl.⁴: **G01N 21/88**

(30) Priorität: **18.07.86 DE 3624379**

(43) Veröffentlichungstag der Anmeldung:
**27.01.88 Patentblatt 88/04**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Merkenschlager, Hans-Hermann, Dipl.-Ing.**
**Spielfeldstrasse 15**
**D-8900 Augsburg 21(DE)**
Erfinder: **Kraus, Friedrich**
**Augsburgerstrasse 20 A**
**D-8901 Adelsried(DE)**
Erfinder: **Szolnoki, Gergely, Dipl.-Ing.**
**Gladiolenstrasse 21**
**D-8900 Augsburg 21(DE)**

(54) **Verfahren zum Prüfen auf fehlerhafte durchkontaktierte Bohrungen bei gedruckten Leiterplatten.**

(57) Die Erfindung bezieht sich auf ein Verfahren zum Prüfen auf fehlerhafte durchkontaktierte Bohrungen (2) bei gedruckten Leiterplatten (3) mittels eines Lichtsenders auf der einen Seite der jeweiligen Bohrung und einem Empfänger auf der anderen Seite, der das durch die Fehlerstellen der durchkontaktierten Bohrung dringende Licht empfängt. Dabei wird nach dem Durchkontaktieren um die zu beurteilende Bohrung (2) eine ringförmige Öffnung (1) angebracht, deren Tiefe geringfügig kleiner als die Leiterplattendicke ist. Diese ringförmige Öffnung wird beleuchtet. Das durch die Bohrung (2) dringende Licht zeigt dann die Fehlerstellen (4), an deren eine mangelhafte Durchkontaktierung erfolgt ist.

## Verfahren zum Prüfen auf fehlerhafte durchkontaktierte Bohrungen bei gedruckten Leiterplatten

Die Erfindung betrifft ein Verfahren zum Prüfen auf fehlerhaft durchkontaktierte Bohrungen bei gedruckten Leiterplatten mittels einem Lichtsender auf der einen Seite der jeweiligen Bohrung und einem Empfänger auf der anderen Seite der das durch die Fehlerstellen der durchkontaktierten Bohrung dringende Licht empfängt.

Um Leiterplatten auf fehlerhaft durchkontaktierte Bohrungen zu überprüfen, werden Proben aus dem Leiterplattennutzen herausgenommen, seitlich soweit abgeschliffen, bis die Bohrungen hälftig entfernt sind und auf der gegenüberliegenden Seite die Platte bis ca. 1mm an die Lochwände hin abgeschliffen. Dann wird mittels einer Lichtquelle Licht an dieser gegenüberliegenden Seite auf die Bohrung gestrahlt und im Gegenlicht der eventuelle Lichtdurchtritt beobachtet, der auftretende Poren in der Metallisierung anzeigt.

Bei diesem Verfahren muß jedoch die zu prüfende Leiterplatte zerstört werden, und das Herrichten der Probe nimmt erhebliche Zeit in Anspruch.

Aus der europäischen Patentanmeldung 111 404 ist es auch bereits bekannt, auf der einen Seite der Bohrung einen Lichtsender und auf der anderen Seite einen Lichtempfänger anzuordnen, die jeweils zu prüfende Bohrung auf der Lichtsenderseite abzudecken und das dann lediglich durch eventuelle Poren der Durchkontaktierungen tretende Licht mit Hilfe des Lichtempfängers zu empfangen.

Dieses Prüfverfahren eignet sich jedoch nicht für Mehrlagenleiterplatten oder strukturierte Leiterplatten, da die jeweilige Metallschicht den Lichtdurchtritt verhindern würde. Zudem kann dieses Prüfverfahren erst nach Abschluß des Fertigungsverfahrens durchgeführt werden.

Aufgabe der vorliegenden Erfindung ist es ein Prüfverfahren zu schaffen, das auch bei durchkontaktierten Mehrlagenleiterplatten vor Strukturierung der Außenlagen ohne Probenentnahme eine Prüfung auf fehlerhafte Durchkontaktierung gestattet.

Zur Lösung dieser Aufgabe wird gemäß der Erfindung derart verfahren, daß nach dem Durchkontaktieren ringförmige Öffnungen um die zu beurteilende Bohrung angebracht werden, deren Tiefe geringfügig kleiner als die Leiterplattendicke ist und daß diese ringförmige Öffnung beleuchtet wird.

Durch diese Maßnahmen erhält man ein Prüfverfahren, das voll in den Fertigungsablauf integrierbar ist, wodurch die Fertigungsdurchlaufzeit erheblich verkürzt wird. Außerdem kann durch dieses Verfahren die ganze Bohrung anstelle der halben bei dem erstgenannten bekannten Verfahren beobachtet werden, wodurch die Sicherheit der Beurteilung erhöht wird. Zudem verbleibt die zu prüfende Probe im Leiterplattennutzen, so daß dadurch die Fehlerzuordnung ebenfalls vereinfacht wird. Außerdem ist dieses Verfahren für Mehrlagenleiterplatten oder strukturierte Leiterplatten gleichermaßen verwendbar.

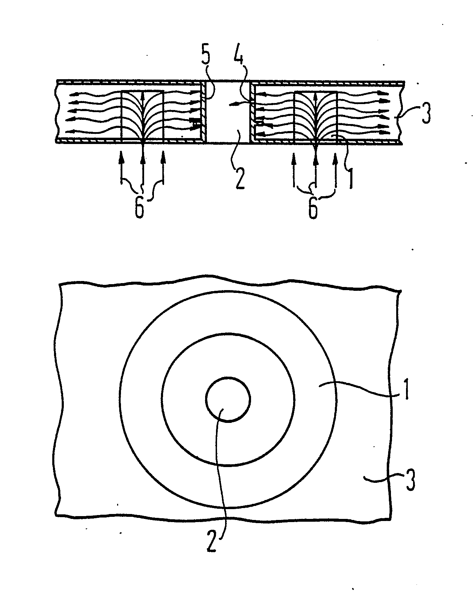

Anhand des Ausführungsbeispiels nach der Figur wird die Erfindung näher erläutert.

Die Figur zeigt einen Ausschnitt aus einer Leiterplatte in der Nähe einer durchkontaktierten Bohrung 2 in einer Leiterplatte 3. Rund um die Bohrung 2, die durchgehend mit einer Metallisierung 5 versehen ist, wird eine ringförmige Öffnung, z.B. mit Hilfe eines Kronenbohrers angebracht, wobei die Tiefe der ringförmigen Öffnung 1 geringfügig kleiner ist als die Dicke der Leiterplatte 3. Diese Öffnung wird mit einer Lichtquelle 6 beleuchtet. Durch die Fehlerstellen 4 dringt dann das Licht in die Bohrung 2 ein und kann z.B. mit einem Lichtempfänger beobachtet werden.

## Ansprüche

Verfahren zum Prüfen auf fehlerhaft durchkontaktierte Bohrungen bei gedruckten Leiterplatten mittels einem Lichtsender auf der einen Seite der jeweiligen Bohrung und einem Empfänger auf der anderen Seite der das durch die Fehlerstellen der durchkontaktierten Bohrung dringende Licht empfängt,
**dadurch gekennzeichnet,** daß nach dem Durchkontaktieren eine ringförmige Öffnung (1) um die zu beurteilende Bohrung (2) angebracht werden, deren Tiefe geringfügig kleiner als die Leiterplattendicke ist und daß diese ringförmige Öffnung (1) beleuchtet wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | EP-A-0 111 404 (FUJITSU LTD.) * ganze Schrift * | 1 | G 01 N 21/88 |
| A | US-A-3 698 821 (J. EKSTRAND) * Spalte 1, Zeilen 6-51; Figur 4 * | 1 | |
| A | US-A-4 145 714 (R.W. McDONALD) * Spalte 1, Zeilen 10-35; Spalte 2, Zeilen 37-58; Figur 2 * | 1 | |
| A | PATENT ABSTRACTS OF JAPAN, Band 9, Nr. 127 (P-360)[1850], 31. Mai 1985; & JP - A - 60 010 158 (FUJITSU K.K.) 19.01.1985 | 1 | |
| A,P | PATENT ABSTRACTS OF JAPAN, Band 10, Nr. 206 (P-478)[2262], 18. Juli 1986; & JP - A - 61 045 955 (FUJITSU LTD.) 06.03.1986 (Kat. A) | 1 | RECHERCHIERTE SACHGEBIETE (Int. Cl.4) G 01 N 21/00 |

Der vorliegende Recherchenbericht wurde für alle Patentansprüche erstellt.

| Recherchenort | Abschlußdatum der Recherche | Prüfer |
|---|---|---|
| BERLIN | 13-10-1987 | BRISON O.P. |